(19) Europäisches Patentamt
European Patent Office
Office européen des brevets

(11) EP 0 969 515 A2

(12) **EUROPÄISCHE PATENTANMELDUNG**

(43) Veröffentlichungstag:
05.01.2000 Patentblatt 2000/01

(51) Int. Cl.⁷: **H01L 29/737**

(21) Anmeldenummer: 99110028.0

(22) Anmeldetag: 21.05.1999

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **29.05.1998 DE 19824110**

(71) Anmelder: **DaimlerChrysler AG**
**70567 Stuttgart (DE)**

(72) Erfinder:
• **Jorke, Helmut**
**89547 Gerstetten (DE)**
• **Luy, Johann-Friedrich, Dr.**
**89073 Ulm (DE)**

(54) **Resonanz Phasen Transistor mit Laufzeitverzögerung**

(57) Silizium-Germanium-Heterobipolartransistor mit einem Silizium-Emitter 1, einer Silizium-Germanium-Basis 2 und einem Silizium-Kollektor 3, derart, daß, ausgehend vom Emitter 1, die Basis 2 eine stufenförmig ansteigende Änderung des Ge-Gehalts und/oder eine ebenso stufenförmige, jedoch gegenläufige Änderung der Dotierkonzentration aufweist, wobei die Stufenhöhe energetisch gesehen größer ist, als die Energie der optischen Phononenenergie des Halbleitermaterials.

FIG.3

EP 0 969 515 A2

Printed by Xerox (UK) Business Services
2.16.7/3.6

**Beschreibung**

Die Erfindung bezieht sich aufeinen bipolaren Transistor nach dem Oberbegriff des Patentanspruchs 1.

Zur Erzeugung von Hochfrequenzleistung spielen bisher nur Diodenoszillatoren eine maßgebliche Rolle. Dagegen wurden Transistoren aufgrund des verhältnismäßig hohen Basisbahnwiderstands für derartige Oszillatoren als ungeeignet erachtet. (S. Luryi, „Ultrafast operation of heterostruetures bipolar transistors resulting from coherent base transport of minority carriers", Proc. ISDRS '93 Charlottesville, 1993, pp. 59).

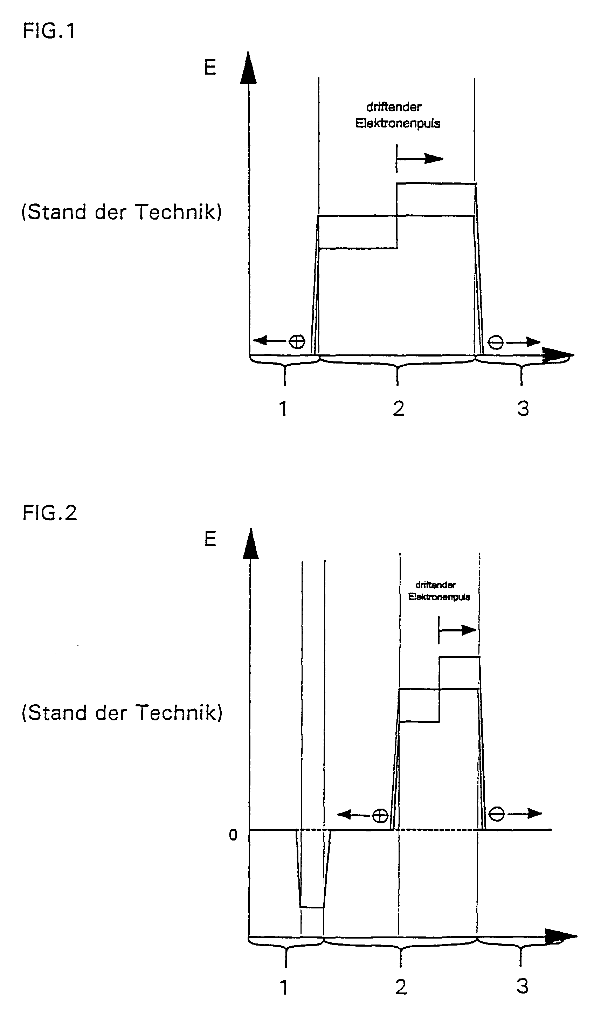

Die Funktionsweise einer pin -Laufzeitdiode als typisches Beispiel eines Diodenoszillators ist in Fig. 1 durch die elektrische Feldverteilung E im p-Emitter 1, i-Driftzone 2 und n-Kollektor 3 schematisch dargestellt. Durch die Flächenladung der driftenden Elektronen wird der Laufraum in ein Gebiet größerer Feldstärke vor den Elekronen und in ein Gebiet kleinerer Feldstärke hinter den Elektronen geteilt. Bei konstantem Emitter-Kollektor-Potential steigen sowohl emitter- als auch kollektorseitig die Feldstärken während der Drift der Elektronen stetig an. Da im Innern von Emitter 1 und Kollektor 3 die Feldstärken verschwinden, bedeutet dieser Anstieg einen Abfluß von Elektronen im n-Gebiet und einen Abfluß von Defektelektronen im p-Gebiet. Dieser Influenzstrom kann während des Drifts der Elektronen im äußeren Stromkreis gemessen werden. Beim Bipolartransistor gelten nach Fig. 2 analoge Betrachtungen, wenn die gewünschte Phasenverschiebung des Kollektorstroms durch die Laufzeit in der Basis-Kollektor-Raumladungszone erzeugt wird. Der Influenzstrom fließt dann im Basis-Kollektor-Stromkreis. Jedoch liegt gerade in diesem Kreis der relativ hohe Basiswiderstand (typischerweise >50Ω), so daß diese Konfiguration für eine Entdämpfung eines äußeren Schwingkreises ungünstig ist.

Bisher sind Silizium-Germanium-Bipolartransistoren aus den Schriften DE 42 41 609, DE 43 01 333 und DE 196 17 030 bekannt die lediglich eine Basis einheitlicher Dotierungs- und Germaniumkonzentration enthalten oder eine einfache Variation in der Dotierungs- oder Germaniumkonzentration aufweisen, die einen hohen Basiswiderstand verursachen und dadurch den beschriebenen Nachteil aufweisen.

Der Erfindung liegt die Aufgabe zugrunde, eine bipolare Si/SiGe Heterotransistor-Struktur anzugeben, bei der die endliche Laufzeit der Ladungsträger in der Basis zur Erzeugung eines negativen Ausgangswiderstands genutzt wird und um in Phase liegende Anteile des Influenzstroms im Emitter-Kollektor Stromkreis zu minimieren.

Die Erfindung wird durch die Merkmale des Patentanspruchs 1 wiedergegeben. Die weiteren Ansprüche enthalten vorteilhafte Aus- und Weiterbildungen der Erfindung.

Der erfindungsgemäße Silizium-Germanium-Bipolartransistor besitzt, ausgehend vom Emitter, im Bereich der Basis eine stufenförmig ansteigende Änderung des Ge-Gehalts allein oder auch eine ebenso stufenförmige jedoch gegenläufige Änderung der Dotierkonzentration mit einer Stufenhöhe derart, daß energetisch gesehen Stufenhöhen entstehen, die größer sind, als die der optischen Phononenenergie des Halbleitermaterials.

Besonders vorteilhaft ist eine stufenförmig ansteigende Änderung des Ge-Gehalts in Verbindung mit einer ebenso stufenförmigen, jedoch gegenläufigen Änderung der Dotierkonzentration.

Typischerweise enthält die Basis drei bis sieben Stufen bei einer gesamten Dicke von 50 bis 300nm. Der Germaniumgehalt liegt bevorzugt zwischen 6 bis 30% und die Dotierung im Falle einer p-Dotierung bei einer Konzentration zwischen $8 \times 10^{19}$ bis $5 \times 10^{18}$ cm$^{-3}$.

Ein besonderer Vorteil der Erfindung besteht darin, daß die normalerweise ungerichtete Diffusion in der Basis einer Transistorstruktur durch die Abstufung in der Germaniumkonzentration oder der Dotierkonzentration, einschließlich die Kombination beider, in der Basis gerichtet wird.

Im folgenden wird die Erfindung anhand von vorteilhaften Ausführungsbeispielen unter Bezugnahme aufschematische Zeichnungen in den Figuren näher erläutert. Es zeigen:

Fig. 1    Elektrische Feldverteilung in einer pin-Laufzeitdiode (Stand der Technik),

Fig. 2    Elektrische Feldverteilung in einem Bipolartransistor (Stand der Technik),

Fig. 3    Eine Schichtenfolge des erfindungsgemäßen Silizium-Germanium-Bipolartransistors,

Fig. 4    Vereinfachte elektrische Feldverteilung des erfindungsgemäßen Silizium-Germanium-Bipolartransistors.

Im Ausführungsbeispiel wird durch eine stufenförmige Variation der Germaniumkonzentration oder eine ebenso stufenförmige Variation der Dotierkonzentration ein stufenförmiger Verlauf des Leitungsbandminimums im Bereich der Basis mit annähernd konstanter Stufenhöhe Δ erzielt. Wählt man Δ größer als die Energie der optischen Phononen, hat dies eine rasche Thermalisierung der Elektronen beim Übertritt zur nächsten, energetisch niedrigeren Stufe zur Folge.

Die Transistzeit Δτ innerhalb einer Stufe kann mit dem Diffusionsansatz beschrieben werden:

$$\Delta\tau = \frac{\Delta W^2}{2D_n}$$

(ΔW ... Stufenweite, $D_n$ ... Elektronen Diffusionskonstante)

Die gesamte Basis-Transistzeit $\tau_B$ über alle Stufen beträgt dann:

$$\tau_B = N\Delta\tau = \frac{N\Delta W^2}{2D_n} \text{ , mit N...Stufenanzahl}$$

Die optische Phononenenergie in Silizium-Germaniumschichten liegt bei Ge-Gehalten von 0% bei 63meV, von 100% bei 37meV und kann für dazwischenliegende Ge-Gehalte linear extrapoliert werden.

Die gesamte Emitter-Kollektor-Transitzeit besteht bei Hochstrom-Injektion im wesentlichen aus der Basis-Transitzeit $\tau_B$ und der Kollektor-Transitzeit. Durch die Wahl einer hinreichend dünnen Kollektorschicht ist die Kollektor-Transitzeit gegenüber der Basis-Transitzeit vernachlässigbar klein. Die Endlichkeit der Basis-Transitzeit führt zu einer Phasenverschiebung zwischen dem zeitabhängigen Emitter-Basis-Potential $U_{EB}$ und dem Kollektorstrom $I_C$. Bei einer ausreichend großen Phasenverschiebung kann der Transistor bei hinreichend geringen parasitären Widerständen einen negativen Ausgangswiderstand zeigen, was zur Entdämpfung eines Schwingkreises genutzt werden kann. Mit $D_n = 5cm^2/s$ und N = 5 läßt sich für die Frequenzen des V-Bandes (50-75GHz) die erforderliche gesamte Basisweite auf ca. 200nm abschätzen. Eine Abstufung des Leitungsbandverlaufs unter der Bedingung, daß Δ größer als die Energie der optischen Phononen ist, kann prinzipiell durch eine Abstufung der Germaniumkonzentration und der Dotierkonzentration erfolgen.

Die Höhe der Energiestufe bei Variation Δx der Germaniumkonzentration folgt nährungsweise aus

$$\Delta = 0.74 \, \Delta x.$$

Die Höhe der Energiestufe bei Variation der Dotierkonzentration folgt nährungsweise aus $\Delta = kT \ln(N_i/N_{i+1})$, mit k...Boltzmannkonstante und T... absolute Temperatur.

Die Tabelle 1 gibt beispielhaft Werte für die Energiestufen infolge von Variation Δx der Germaniumkonzentration und der Dotierkonzentration wieder.

Tab. 1

| Energiestufen: | | | |
|---|---|---|---|
| Δx (%) | Δ (meV) | $N_i/N_{i+1}$ | Δ (meV) |
| 3 | 22 | 2 | 18 |
| 4 | 30 | 3 | 29 |
| 5 | 37 | 5 | 41 |
| 6 | 44 | 10 | 58 |
| 7 | 52 | | |
| 8 | 59 | | |

Bei Berücksichtigung der Randbedingungen des pseudomorphen und defektfreien Wachstums der Silizium-Germanium-Basis beim Herstellungsprozeß, wird die gewünschte Stufenhöhe besonders vorteilhaft aus der Kombination beider Variationsmöglichkeiten erzeugt. Im Ausführungsbeispiel wurde die Abstufung Δx = 6% und $N_i/N_{i+1}$ = 2 gewählt. Dies führt zu den in Tab. 2 dargestellten Konzentrationen. Ein weiteres Ausführungsbeispiel kann in der Kombination Δx = 4% und $N_i/N_{i+1}$ = 3 realisiert werden.

Tab. 2

| Stufenprofil bei N = 5 und Δx = 6% und $N_i/N_{i+1}$ =2: | | |
|---|---|---|
| Schicht | x (%) | $N_i$ $(cm^{-3})$ |
| 1 (Emitterseite) | 6 | $8 \times 10^{19}$ |

Tab. 2 (fortgesetzt)

| Stufenprofil bei N = 5 und $\Delta x$ = 6% und $N_i/N_{i+1}$ =2: | | |
|---|---|---|
| Schicht | x (%) | $N_i$ (cm$^{-3}$) |
| 2 | 12 | $4 \times 10^{19}$ |
| 3 | 18 | $2 \times 10^{19}$ |
| 4 | 24 | $1 \times 10^{19}$ |
| 5 | 30 | $5 \times 10^{18}$ |

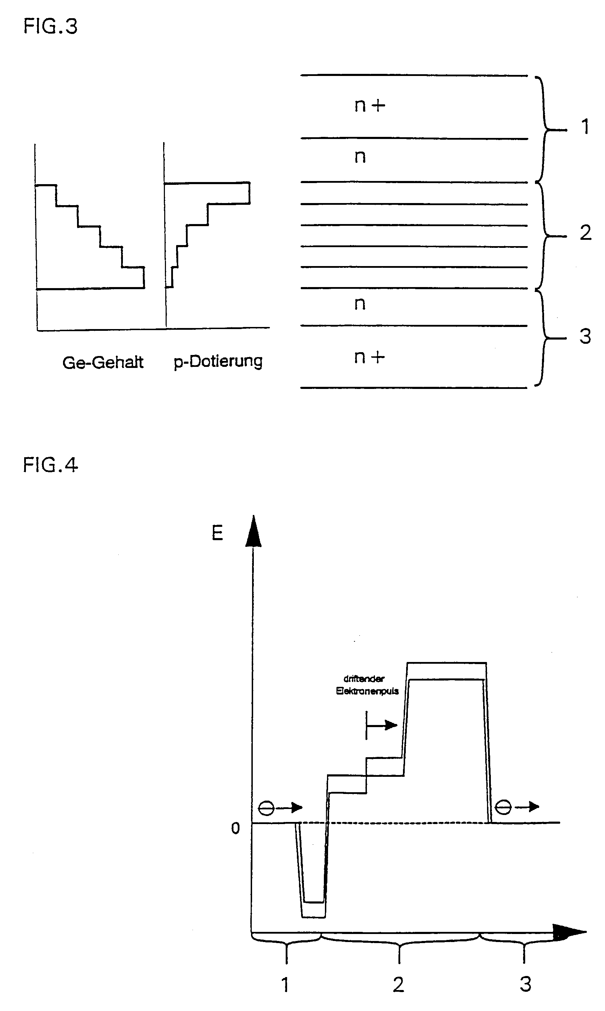

Die zugehörige Schichtenfolge des Silizium-Germanium-Bipolartransistors gemäß Fig. 3 zeigt die Abstufungen der Germaniumkonzentration und beispielhaft die p-Dotierungskonzentration in der Basis 2, beides in linearer Auftragung. Ebenfalls dargestellt ist der n-Silizium-Emitter 1 mit n$^+$-Anschlußschicht sowie der n-Silizium-Kollektor 3 mit n$^+$- Anschlußschicht. Auf der Emitterseite der Basis ist die Germaniumkonzentration bei der ersten Stufe am geringsten, wohingegen die Dotierkonzentration dort den höchsten Wert aufweist.

In Fig. 4 wird gegenüber dem in den Fig. 1 und 2 beschriebenen Stand der Technik die durch die Erfindung beschriebene Auswirkung auf die elektrische Feldverteilung E schematisch dargestellt. Eine durch die Abstufung des Potentials erzeugte Modulation im elektrischen Feld innerhalb der Basis wird aus Gründen der Übersichtlichkeit in Fig. 4 nicht dargestellt.

Die Feldstärke in der Emitter-Basis-Raumladungszone nimmt während des Drifts der Elektronen stetig ab, wohingegen die Feldstärke in der Basis-Kollektor Raumladungszone stetig ansteigt. Dabei bleibt das Emitter-Kollektor-Potential als Summe aus dem Emitter-Basis-Potential und dem Basis-Kollektor-Potential konstant. Es fließen somit Elektronen in der dargestellten Weise im Emitter 1 zu, während im Kollektor 3 Elektronen abfließen. Der Influenzstrom fließt dann im Emitter-Kollektor-Stromkreis, die Basis-Zuleitung bleibt stromfrei und hat dadurch keinen Beitrag zum Gesamtwiderstand.

**Patentansprüche**

1.   Silizium-Germanium-Heterobipolartransistor mit einem Silizium-Emitter (1), einer Silizium-Germanium-Basis (2) und einem Silizium-Kollektor (3), <u>dadurch gekennzeichnet,</u>
daß, ausgehend vom Emitter (1), die Basis (2) eine stufenförmig ansteigende Änderung des Ge-Gehalts und/oder eine ebenso stufenförmige, jedoch gegenläufige Änderung der Dotierkonzentration aufweist.

2.   Silizium-Germanium-Heterobipolartransistor nach Anspruch 1, dadurch gekennzeichnet, daß die Basis (2) drei bis sieben Stufen enthält.

3.   Silizium-Germanium-Heterobipolartransistor nach Anspruch 1, dadurch gekennzeichnet, daß die Dicke der Basis (2) 50 nm bis 300 nm beträgt.

4.   Silizium-Germanium-Heterobipolartransistor nach einem der vorhergehenden Ansprüche, dadurch gekennzeichnet, daß die Basis (2) aus Stufen mit einem Ge-Gehalt zwischen 6 bis 30% und einer p-Dotierkonzentration zwischen $8 \times 10^{19}$ bis $5 \times 10^{18}$ cm$^{-3}$ ausgebildet ist.

FIG.1

E

(Stand der Technik)

driftender
Elektronenpuls

$\oplus$

$\ominus$

1    2    3

FIG.2

E

(Stand der Technik)

driftender
Elektronenpuls

$\oplus$

$\ominus$

0

1    2    3

FIG.3

Ge-Gehalt   p-Dotierung

n +
n
}1

}2

n
n +
}3

FIG.4

E

driftender
Elektronenpuls

0

⊖→

⊖→

1   2   3